# EUROPEAN PATENT APPLICATION

(11) **EP 4 776 584 A1**
(43) Date of publication of application: **15.07.2026**
(21) Application number: 25305037.1
(22) Date of filing: 14.01.2025
(51) Int. Cl.: H04L 25/06, H03K 5/08

(54) **FAST-SETTLING THRESHOLD ESTIMATOR FOR A BIT SLICER**

(71) Applicant: NXP USA, Inc., Austin TX 78735 (US)
(72) Inventor: de Jong, Gerben Willem, 5656 AG Eindhoven (NL); Stoorvogel, Hans Peter, 5656 AG Eindhoven (NL); Copani, Tino, 5656 AG Eindhoven (NL); Crand, Olivier, 31023 Toulouse Cedex 1 (FR)
(74) Representative: Schmütz, Christian Klaus Johannes

(57) **Abstract**

An electronic circuit includes a fast-settling threshold estimator for determining a fast-settling threshold voltage which includes a maximum peak detector that receives an analog signal containing digital data and produces an estimate of a maximum value of the analog signal; a differentiator that produces an output voltage responsive to a change in the estimate of a maximum value of the analog signal; a preselected voltage coupled to a comparator that outputs a pulse when the output voltage is greater than the preselected voltage; a minimum peak detector that produces an estimate of a minimum value of the analog signal; and an averaging circuit that produces a weighted average of the estimate of a maximum value of the analog signal and the estimate of a minimum value of the analog signal. In one embodiment, the fast-settling threshold estimator is coupled to a bit slicer and to a RF receiver.

## Description

### BACKGROUND

### Field

This invention relates generally to electronic circuits, and more specifically to a threshold estimator for a bit slicer.

### Related Art

A wireless receiver that receives a radio frequency analog signal representing digital data typically includes a demodulator that converts a frequency of the analog signal to a baseband frequency and outputs a demodulated signal to a bit slicer. The demodulated signal may represent a combination of an amplitude of the analog signal, noise, interference from other received signals, and distortion caused by circuitry of the wireless receiver. The bit slicer detects a binary signal within the demodulated signal by continually comparing a voltage of the demodulated signal with a threshold voltage. If the voltage of the demodulated signal is higher than the threshold voltage, then an output of the bit slicer goes high which is usually interpreted to represent a digital "1". If the voltage of the demodulated signal is lower than the threshold voltage, then the output of the bit slicer goes low which is usually interpreted to represent a digital "0". The bit slicer may be coupled to a threshold estimator that estimates a value of the threshold voltage based, at least in part, on characteristics of the demodulated signal.

### SUMMARY

Aspects of the present disclosure are defined in the accompanying claims.

### BRIEF DESCRIPTION OF THE DRAWINGS

The present invention is illustrated by way of example and is not limited by the accompanying figures, in which like references indicate similar elements.
**FIG. 1** is a simplified functional block diagram of a radio frequency (RF) receiver coupled to a fast-settling threshold estimator and to a bit slicer.
**FIG. 2** is a simplified functional block diagram of the fast-settling threshold estimator of FIG. 1 in accordance with one embodiment of the invention, coupled to the bit slicer.
**FIG. 3** is a simplified functional block diagram of a maximum peak detector, in accordance with one embodiment of the invention.
**FIG. 4** is a simplified functional block diagram of a minimum peak detector, in accordance with one embodiment of the invention.
**FIG. 5** is a simplified functional block diagram of a first example of an integrator in accordance with one embodiment of the invention.
**FIG. 6** is a simplified functional block diagram of a second example of an integrator in accordance with one embodiment of the invention.
**FIG. 7** is a graph of signals present in a simulation of the fast-settling threshold estimator shown in FIG. 2.
**FIG. 8** is another graph of signals present in a simulation of the fast-settling threshold estimator shown in FIG. 2.
**FIG. 9** is a simplified functional block diagram of a minimum peak detector with a simplified reset circuit, in accordance with one embodiment of the invention.

### DETAILED DESCRIPTION

A fast-settling threshold estimator in accordance with the invention receives an analog signal and outputs a threshold voltage to a bit slicer that also receives the analog signal. The threshold voltage advantageously settles very fast, i.e., it has a high attack, at a beginning of a data packet (hereinafter "packet") and the threshold voltage is advantageously very stable during the packet. The fast-settling threshold estimator includes a differentiator that detects a sudden change in voltage of an output signal of a maximum peak detector. The fast-settling threshold estimator initializes a minimum peak detector at a beginning of every packet which is typically when the sudden change in voltage of the output signal of the maximum peak detector occurs. A bit slicer contributes to reconstruction of original bits in the analog signal by comparing a voltage of the analog signal with a threshold voltage.

To obtain a fast-settling of a threshold estimation, both the maximum peak detector and the minimum peak detector should settle quickly at the beginning of each packet. Fast-settling of the threshold estimation requires a temporarily fast decay of an output of the minimum peak detector. A fast decay requires a large decay current. Advantageously, the minimum peak detector in accordance with the invention has a temporarily large decay current. A peak detector should also produce an output signal that is flat versus time. A flat threshold level versus time requires a slow decay. Advantageously, both peak detectors in the fast-settling threshold estimator in accordance with the invention have a small decay current during most of each packet.

At the beginning of a packet, the maximum peak detector is in attack mode; therefore, the maximum peak detector is fast. At the beginning of a packet, the minimum peak detector is in decay mode. Known minimum peak detectors disadvantageously decay slowly at the beginning of a packet. However, the fast-settling threshold estimator in accordance with the invention overcomes this deficiency by "initializing" the minimum peak detector, which means that a decay speed of the minimum peak detector is temporarily increased. Only temporarily, because a permanent increase of the decay speed would result in a non-flat threshold level versus time. With initialization of the minimum peak detector, the output voltage of the minimum peak detector quickly settles to a current value of the analog signal. The quick settling is done by temporarily increasing the decay speed of the minimum peak detector. Consequently, the minimum peak detector in accordance with the invention advantageously balances a fast-settling of the threshold estimation with a flat threshold level versus time.

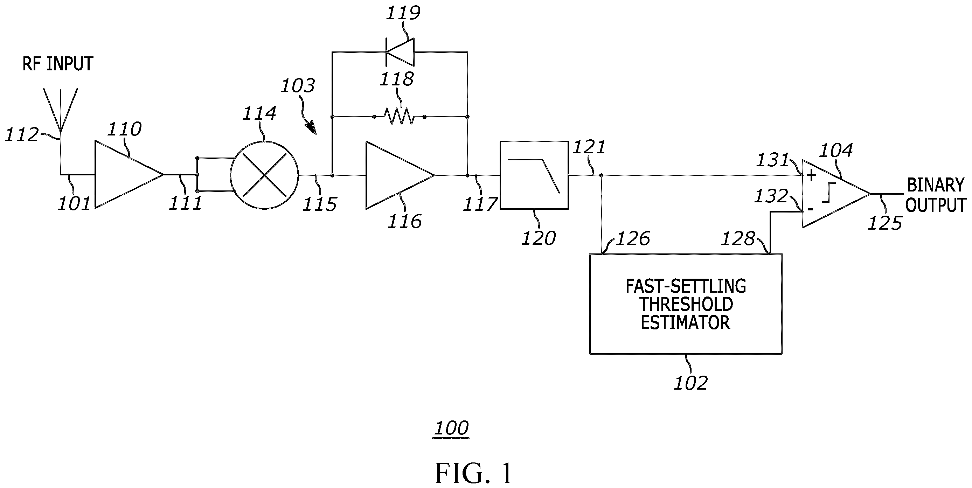

**FIG. 1** is a simplified functional block diagram of electronic circuits **100** comprising a radio frequency (hereinafter "RF") receiver **103** coupled to a fast-settling threshold estimator **102** and to a bit slicer **104.** The RF receiver **103** may receive an RF analog signal **101** representing digital data. The RF receiver **103** includes an RF low-noise amplifier **110** coupled to an antenna **112** for receiving the RF analog signal **101,** and for outputting an amplified RF analog signal **111.** In one embodiment, the RF signal is a 60.5-GHz on/off-keying-modulated (OOK) RF carrier with a minimum on-level of -42 dBm. The RF low-noise amplifier **110** is coupled to an RF-envelope detector **114,** which is a self-mixer. The RF-envelope detector **114** downmixes the amplified RF analog signal **111** to a baseband analog signal **115.** The RF-envelope detector **114** is coupled to a baseband transimpedance amplifier (hereinafter "TIA") **116** that outputs an amplified baseband analog signal **117.** In the illustrated embodiment, a feedback resistor **118** is coupled between an input terminal and an output terminal of the baseband TIA **116.** In the illustrated embodiment, the RF-envelope detector **114** is a quadratic envelope detector. In another embodiment, the RF-envelope detector **114** is an absolute-law envelope detector. In yet another embodiment, a semi-logarithmic RF-envelope detector is included within a semi-logarithmic baseband TIA **116** in which case a diode **119** is coupled between the input terminal and the output terminal of the baseband TIA **116** in parallel with the feedback resistor **118.** Although diode **119** is used with the illustrated implementation of the semi-logarithmic baseband TIA **116;** an actual implementation of the semi-logarithmic TIA would be more complicated. A semi-logarithmic transfer offers an instantaneous reduction of dynamic range, without introducing any settling issues. Therefore, the use of a semi-logarithmic transfer is advantageous, given the large dynamic range of the RF analog signal **101,** combined with the requirement for fast settling.

The TIA **116** is coupled to a baseband low-pass filter **120.** In one embodiment, the baseband low-pass filter **120** is a 300MHz second-order Butterworth filter. The baseband low-pass filter **120** outputs a filtered amplified baseband analog signal (hereinafter "analog signal") **121** to an input terminal **126** of the fast-settling threshold estimator **102** and to a first input terminal **131** of the bit slicer **104.** In one embodiment, the analog signal **121** has a voltage between 0V and 1V. An output terminal **128** of the fast-settling threshold estimator **102** is coupled to a second input terminal **132** of the bit slicer **104.** In the illustrated embodiment, the bit slicer **104** consists of a bit-slicing voltage comparator having a positive input terminal and a negative input terminal. In one embodiment, a binary output **125** of the bit slicer **104** has a rate of 600Mb per second. The fast-settling threshold estimator **102** and the bit slicer **104** receive a packet of digital data embedded in the analog signal **121.** The packet of digital data usually lacks a well-defined high level and a well-defined low level. Therefore, the fast-settling threshold estimator **102** which determines a slicing level of the digital data in the analog signal **121** is needed.

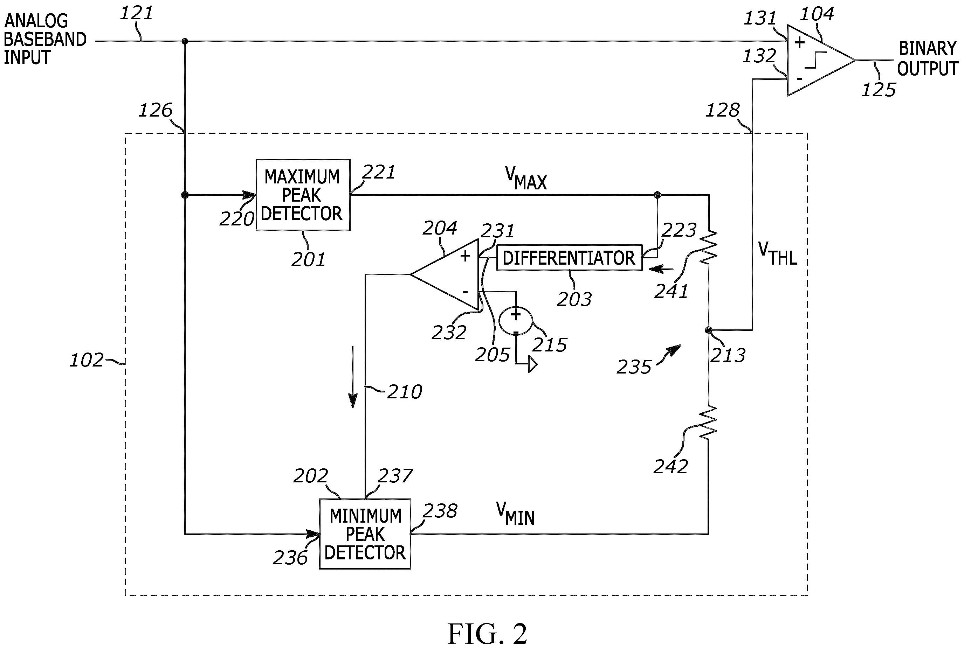

**FIG. 2** is a simplified functional block diagram of the fast-settling threshold estimator **102.** The fast-settling threshold estimator **102** outputs a fast-settling threshold voltage (V_{THL}) that serves as the slicing level of the digital data conveyed by the analog signal **121.** The binary output **125** of the bit slicer **104** is based on the digital data embedded in the analog signal **121** and on V_{THL}.

The fast-settling threshold estimator **102** includes the input terminal **126** for receiving the analog signal **121,** the output terminal **128** coupled to the bit slicer **104,** a maximum peak detector **201,** a minimum peak detector **202,** a differentiator **203,** a voltage comparator (hereinafter "comparator") **204** and an averaging circuit **235.** The maximum peak detector **201** has an input terminal **220** and an output terminal **221.** The maximum peak detector **201** outputs a V_{MAX} signal which corresponds to a maximum value of the analog signal **121.** The minimum peak detector **202** has a first input terminal **236,** a reset input terminal **237** and an output terminal **238.** The minimum peak detector **202** outputs a V_{MIN} signal which corresponds to a minimum value of the analog signal **121.** In the illustrated embodiment, the averaging circuit **235** includes a first resistor **241** having one end coupled to the output terminal **221** of the maximum peak detector **201** and another end coupled to a node **213,** and a second resistor **242** having one end coupled to the output terminal **238** of the minimum peak detector **202** and another end coupled to the node **213.** An output of the averaging circuit **235** is a weighted average of the output voltage of the maximum peak detector **201** and the output voltage of the minimum peak detector **202.** The output of the averaging circuit **235** is the fast-settling threshold voltage V_{THL}. The fast-settling threshold voltage V_{THL} is characterized both by attack speed and decay speed of the maximum peak detector **201** and by attack speed and decay speed of the minimum peak detector **202.**

Known threshold estimators use resistors of equal resistance in their averaging circuit. If the first resistor **241** and the second resistor **242** have equal resistances, then V_{THL} = (V_{MAX} + V_{MIN})/2. However, in some embodiments of the fast-settling threshold estimator **102** the first resistor **241** and the second resistor **242** advantageously have unequal resistances. Optimum values of the first resistor **241** and the second resistor **242** depend upon a type of envelope detector coupled to the fast-settling threshold estimator **102.** Examples of the type of envelope detector are: absolute-law, quadratic and semi-logarithmic. For the absolute-law envelope detector, first resistor **241** and second resistor **242** are approximately equal. For the quadratic envelope detector, first resistor **241** is larger than second resistor **242.** For the semi-logarithmic envelope detector, second resistor **242** is larger than first resistor **241.** The values of first resistor **241** and second resistor **242** also depend, in part, on a signal-to-noise ratio of the RF analog signal **101.** The output of the fast-settling threshold estimator **102** is the threshold voltage (V_{THL}) at node **213.** The fast-settling threshold estimator **102** outputs an optimum slicing level for a particular envelope detector. The optimum slicing level is selected to correspond to a voltage at which the probability density of a high level (a digital "1") plus Gaussian noise equals the probability density of a low level (a digital "0") plus Gaussian noise. The optimum slicing level is determined, in part, by the resistances of the first resistor **241** and the second resistor **242.** The slicing level/threshold is estimated using the maximum peak detector **201** and the minimum peak detector **202** together with the first resistor **241** and the second resistor **242** to obtain a weighted average of a maximum value and a minimum value of the analog signal **121.** The weighted average is controlled by the resistances of the first resistor **241** and the second resistor **242.** In this way, the bit slicer **104** is advantageously insensitive to a slowly varying direct current (DC) component of the analog signal **121.**

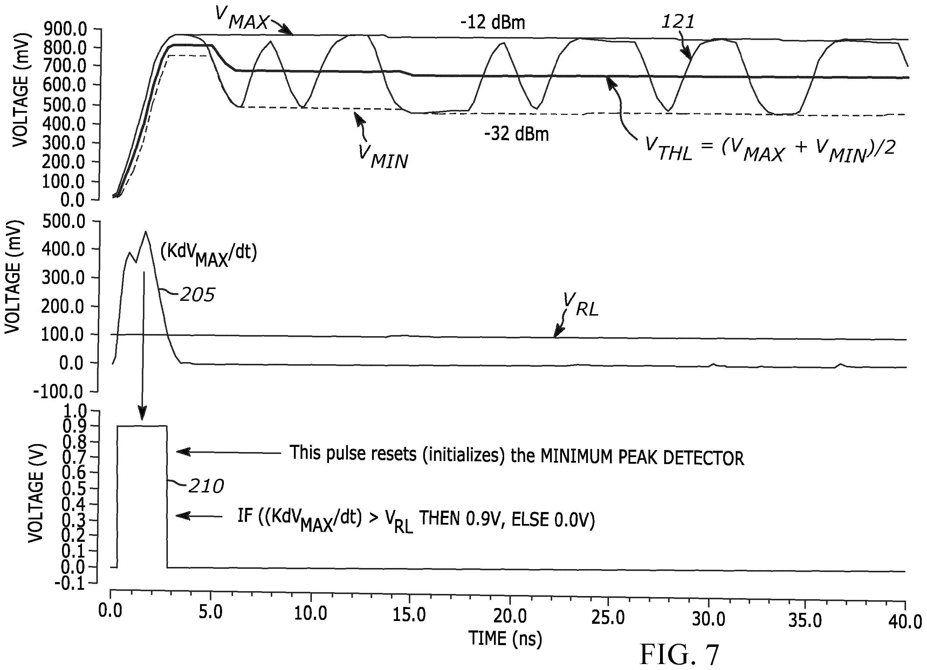

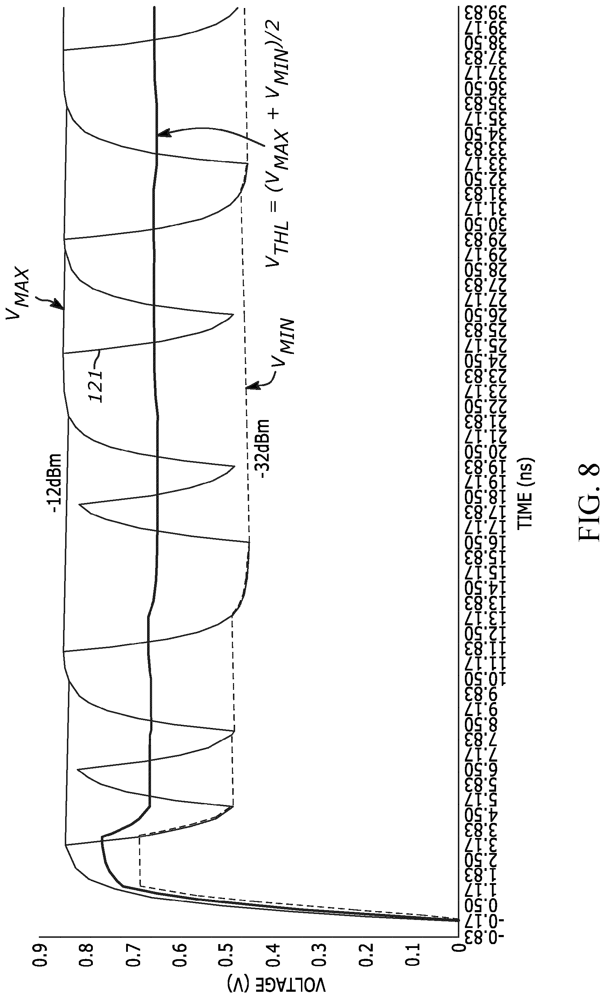

The output terminal **221** of the maximum peak detector **201** is coupled to an input terminal **223** of the differentiator **203.** An output signal **205** of the differentiator **203** is responsive to a rate of change of an output signal V_{MAX} of the maximum peak detector **201.** The output signal **205** of the differentiator **203** is KdV_{MAX}/dt, where K is a gain factor which is expressed in seconds. Note that dV_{MAX}/dt peaks to approximately 1GV/s at the beginning of the packet; therefore, K is approximately 0.5ns. The aforementioned values are based on a simulation some results of which are shown in FIGs. 7 and 8. The output signal **205** of the differentiator **203** is an analog voltage directly proportional to, or linear with, a rate of change of V_{MAX}. An output voltage of the differentiator **203** is highest when V_{MAX} changes most rapidly. As a result, the differentiator **203** detects a start of a packet embedded in an analog baseband signal **121.** The output signal **205** of the differentiator **203** is used to initialize the minimum peak detector **202** to minimize a settling time of the threshold estimation.

The comparator **204** includes a first input terminal **231** for receiving the output signal **205** of the differentiator **203,** and a second input terminal **232** coupled to a constant voltage source **215** having a preselected voltage, V_{RL} (see FIG. 7). The comparator **204** outputs a pulse **210** only when a voltage of the output signal **205** of the differentiator **203** is higher than the voltage V_{RL} of the constant voltage source **215.** In one embodiment, an output voltage of the comparator **204** is 0.9V for approximately 3ns (see FIG. 7) when the voltage of the output signal **205** of the differentiator **203** is higher than the voltage V_{RL} of the constant voltage source **215.** Otherwise, the output voltage of the comparator **204** is 0V. The output voltage of the comparator **204** is as follows: IF (KdV_{MAX}/dt) > V_{RL} THEN 0.9V, ELSE 0.0V. The voltage V_{RL} is preselected to be high enough so that a false pulse from the comparator **204** does not occur. The voltage V_{RL} is also preselected to be low enough to ensure that the pulse **210** from the comparator **204** does occur at the beginning of a packet. In one embodiment, the constant voltage source **215** produces a DC voltage of 100mV which voltage is preselected typically by simulation of the circuitry.

In one embodiment, a first-order low-pass filter (not shown) is inserted between the differentiator **203** and the comparator **204** to avoid false triggers of the comparator. In another embodiment, hysteresis (not shown) is added in the comparator **204** to avoid false triggers of the comparator.

A start of a packet is detected by differentiating an output of the maximum peak detector **201** to initialize the minimum peak detector **202.** Initializing the minimum peak detector **202** minimizes a settling time of an estimation of the slicing level/threshold.

The configuration of the fast-settling threshold estimator **102** illustrated in FIG. 2 is used when a polarity of the analog signal **121** is as shown in FIGs. 7 and 8. If the polarity of the analog signal **121** is opposite to the polarity shown in FIGs. 7 and 8, then the input terminal of the differentiator **203** is coupled to the output terminal of the minimum peak detector **202** (instead of to the output terminal of the maximum peak detector **201)** and the output of the comparator **204** is coupled to the maximum peak detector **201** (instead of to the minimum peak detector **202).** Otherwise, the operation is analogous.

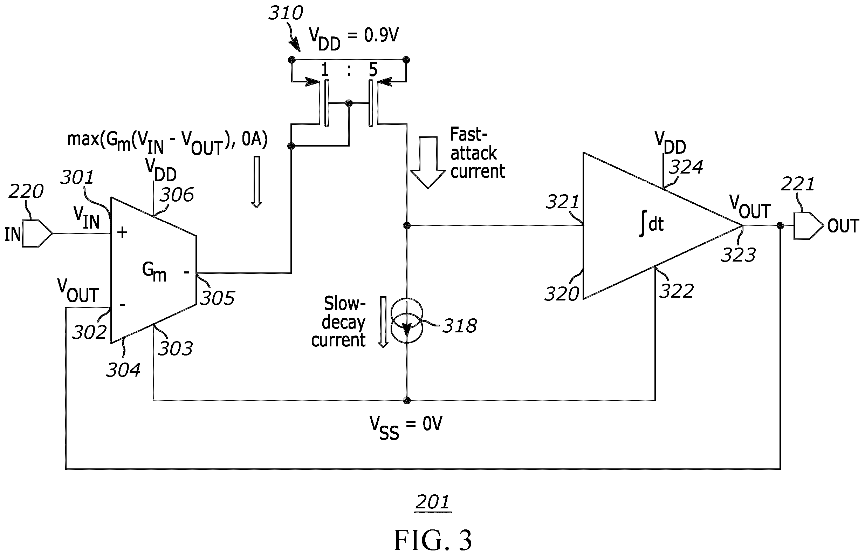

**FIG. 3** is a simplified functional block diagram of the maximum peak detector **201,** in accordance with one embodiment of the invention. The maximum peak detector **201** determines a peak level of an analog signal such as the analog signal **121** outputted by the RF receiver **103.** The maximum peak detector **201** includes a transconductance amplifier **304** having a positive input terminal **301** coupled to the input terminal **220** of the maximum peak detector **201,** a negative input terminal **302** coupled to the output terminal **221** of the maximum peak detector, a terminal **303** coupled to ground potential Vss, a terminal **306** coupled to a supply voltage V_{DD} and a (negative) output terminal **305.** The transconductance amplifier **304** contains a voltage-controlled current circuit coupled internally to output terminal **305.** The transconductance amplifier **304** compares V_{OUT}, which is an output signal of the maximum peak detector **201,** to V_{IN}, which is a voltage of the analog signal **121.** The transconductance amplifier **304** is configured to generate a current Gₘ(V_{IN} - V_{OUT}), where Gₘ is the transconductance. Therefore, the transconductance amplifier **304** generates a positive current only when V_{OUT} is lower than V_{IN}; otherwise, the transconductance amplifier attempts to generate a negative current, which is, however, blocked by the rectifying current mirror **310,** i.e., the current is 0A. Therefore, the transconductance amplifier **304** generates a positive current only when V_{OUT} is lower than the voltage of the analog signal **121;** otherwise, the transconductance amplifier would generate a negative current, which is, however, blocked by the rectifying current mirror, i.e., the current is 0A. In one embodiment, Gₘ has a value of approximately 1mA/V. In one embodiment, V_{OUT} has a value between 0V and 1V, and V_{IN} has a value between 0V and 1V. In one embodiment, an absolute maximum output current of the transconductance amplifier **304** is approximately 200µA. When the fast-settling threshold estimator **102** is in attack mode, in one embodiment, (V_{IN}- V_{OUT}) is less than 0.2V, and in most cases is less than 4mV. Attack mode is a situation when there is attack current flowing, i.e., when (V_{IN} - V_{OUT}) > 0. When a peak detector **201, 202** is in decay mode, in one embodiment, (V_{IN}-V_{OUT}) is approximately -400mV as in the example simulation shown in FIGs. 7 and 8, but can be as large as -900mV in other examples that are not shown. Decay mode is a situation when there is only decay current flowing, so when (V_{IN} - V_{OUT}) < 0. Decay mode and attack mode are mutually exclusive. A peak detector is either in decay mode or in attack mode.

The maximum peak detector **201** includes a current mirror **310** coupled to the output terminal **305** of the transconductance amplifier **304.** The current mirror **310** comprises an input transistor having a source electrode coupled to V_{DD}, a drain electrode coupled to the output terminal **305** and having a gate electrode. The current mirror **310** further comprises an output transistor having a source electrode coupled to V_{DD}, a gate electrode coupled to the gate electrode of the input transistor, and having a drain electrode. The current mirror **310** rectifies and amplifies the output current of the transconductance amplifier **304.** In one embodiment, the amplification factor of the current mirror **310** is "5", and when the maximum peak detector **201** is in attack mode, the current mirror **310** outputs a maximum fast-attack current of approximately 1mA. In such embodiment, when the maximum peak detector **201** is in attack mode, the current mirror **310** outputs a fast-attack current of approximately maximum 1mA, and in most cases not more than 20µA. There is no current from the current mirror **310** when the output current of the transconductance amplifier **304** is zero.

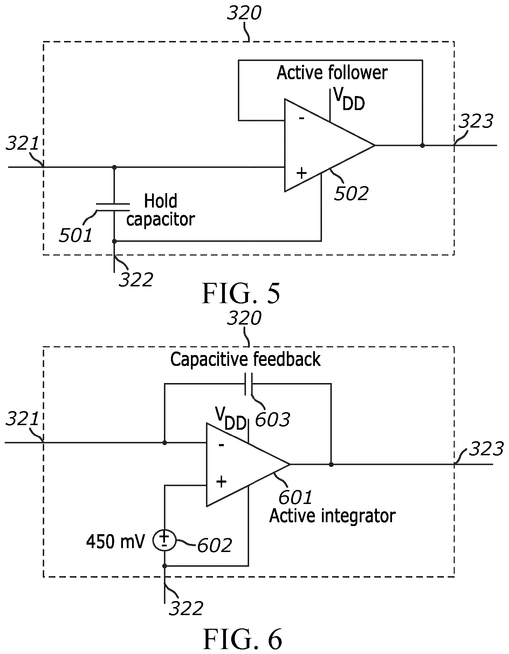

The maximum peak detector **201** includes a slow decay current source **318** coupled between the drain electrode of the output transistor of the current mirror **310** and ground potential. In one embodiment, a fixed value of the slow decay current source **318** is preselected to be approximately 1µA. The maximum peak detector **201** includes an integrator **320** having an input terminal **321** coupled to the output terminal of the current mirror **310,** a terminal **322** coupled to ground potential, an output terminal **323** coupled to the output terminal **221** of the maximum peak detector **201,** and a terminal **324** coupled to V_{DD}. The integrator **320** integrates its input current and delivers the result as an output voltage. A positive component of the output current from the transconductance amplifier **304,** after being amplified by current mirror **310** with a factor of "5", feeds a capacitor **501** (see FIG. 5) in the integrator **320.**

A voltage across the capacitor constitutes V_{MAX}, the output signal of the maximum peak detector **201.** The maximum peak detector **201** includes a fast attack, or charge, current which is generated by the current mirror **310** when the transconductance amplifier **304** outputs a current. The fast attack current allows the voltage across the capacitor to advantageously quickly increase when V_{MAX} is lower than the voltage of the analog signal **121.** When the output current of the transconductance amplifier **304** is zero, there is no attack current, and the capacitor is slowing discharged by a small decay current generated by the slow decay current source **318.** The voltage of the capacitor is buffered by an operational amplifier (see FIG. 5) connected as an active voltage follower in the integrator **320.** The operational amplifier prevents the capacitor from being loaded by other parts of the circuit, allowing the capacitor to maintain its voltage. As the capacitor discharges, the voltage outputted by the maximum peak detector **201** advantageously only slowly goes down. As a result, V_{MAX}, the output voltage of the maximum peak detector **201** advantageously tends to almost hold to a maximum of the input voltage, i.e., the analog voltage **121,** of the maximum peak detector.

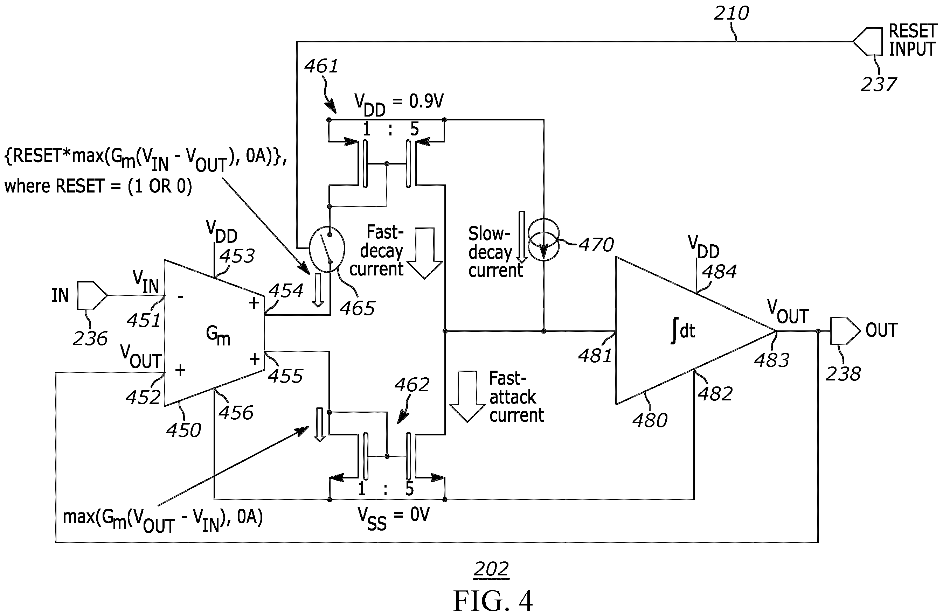

**FIG. 4** is a simplified functional block diagram of the minimum peak detector **202,** in accordance with one embodiment of the invention. The minimum peak detector **202** determines a minimum voltage level of the analog signal **121** advantageously more quickly than known peak detectors by using a RESET signal to initialize, or precharge, the minimum peak detector. Because the minimum peak detector determines the minimum value of its input voltage, the minimum peak detector is initialized with a relatively high voltage but normally less than V_{DD}. This means that the capacitor **501** is precharged to the relatively high voltage level at initialization of the minimum peak detector. The minimum peak detector **202** includes a transconductance amplifier **450** located at an input of the minimum peak detector **202.** The transconductance amplifier **450** has a negative input terminal **451** for receiving the analog signal **121,** a positive input terminal **452** coupled to the output terminal **238** of the minimum peak detector **202,** a third terminal **453** coupled to V_{DD}, a fourth terminal **454** coupled to a first current mirror **461** through a switch **465,** a fifth terminal **455** coupled to a second current mirror **462,** and a sixth terminal **456** coupled to ground potential or Vss.

The first current mirror **461** has an input transistor and an output transistor. The transconductance amplifier **450** contains a first voltage-controlled current circuit internally coupled to the fourth terminal **454.** A sinking current occurs from the first current mirror **461** through the switch **465,** when conductive, to the fourth terminal **454** when Gₘ(V_{IN}- V_{OUT}) is positive. In one embodiment, a maximum sinking current to the fourth terminal **454** is approximately 200µA. The sinking current from the first current mirror **461** to the fourth terminal **454** occurs under the following conditions: RESET = 1 AND Gₘ(V_{IN} - V_{OUT}) is positive.

The second current mirror **462** has an input transistor and an output transistor. The transconductance amplifier **450** contains a second voltage-controlled current circuit internally coupled to the fifth terminal **455.** A sourcing current is outputted from the fifth terminal **455** to the second current mirror **462** when Gₘ(V_{OUT} - V_{IN}) is positive. In one embodiment, a maximum sourcing output current from the fifth terminal **455** is approximately 200µA. A sinking current occurs from the second current mirror **462** to the fifth terminal **455** when Gₘ(V_{OUT} - V_{IN}) is negative. However, that sinking current is blocked by the input transistor of current mirror **462,** which acts as a rectifying diode (gate connected to drain). This is the intended rectification property of the current mirror to distinguish attacking from decaying. Either a sourcing current Gₘ(V_{OUT} - V_{IN}) occurs from the fifth terminal **455** to the second current mirror **462,** or no current occurs between the fifth terminal **455** and the second current mirror **462,** depending upon polarity, or sign, of Gₘ(V_{OUT} - V_{IN}). The output current from the fourth terminal **454** and the output current from the fifth terminal **455** of the transconductance amplifier **450** have equal polarity and phase, as far as the transconductance amplifier **450** is concerned. However, the output current from the fourth terminal **454** or the output current from the fifth terminal **455** might be blocked by one of the rectifying current mirrors **461, 462** depending on direction of the output current, or the output current might be blocked by the switch **465** when it is non-conducting.

The switch **465** is coupled between the fourth terminal **454** of the transconductance amplifier **450** and the input transistor of the first current mirror **461.** When the minimum peak detector **202** receives a RESET signal, i.e., pulse **210,** from the comparator **204,** the switch 465 is conducting. Then, the current Gₘ(V_{IN} - V_{OUT}) from the fourth terminal **454** causes the first current mirror **461** to produce a fast-decay current, assuming the current Gₘ(V_{IN} - V_{OUT}) is positive. The fast-decay current is produced at a drain terminal of the output transistor of the first current mirror **461.** In one embodiment, the switch **465** is a transistor that has a control electrode coupled to the reset input terminal **237** of the minimum peak detector **202** for receiving the pulse **210** from the comparator **204;** the switch also has one conducting electrode coupled to a drain terminal of the input transistor of the current mirror **461** and another conducting electrode coupled to the fourth terminal **454** of the transconductance amplifier **450.**

A response time of the minimum peak detector **202** is small compared to the bit time, i.e., the inverse of the bit rate.

However, most of the time during a packet, the switch **465** is non-conducting; therefore, a potential current Gₘ(V_{IN} - V_{OUT}) to the fourth output terminal **454** is blocked by the switch **465** and does not cause the first current mirror **461** to produce a fast-decay current (or any current). The current to output terminal **454** is amplified by the first current mirror **461.** In one embodiment, the first current mirror **461** has an amplification factor of "5". In one embodiment, the fast-decay current approximately peaks to 0.6mA.

The minimum peak detector **202** includes a non-inverting integrator **480** having an input terminal **481** coupled to an output terminal of the first current mirror **461,** a terminal **482** coupled to ground potential, or Vss, an output terminal **483** coupled to the output terminal **238** of the minimum peak detector **202** and a terminal **484** coupled to V_{DD}. The non-inverting integrator **480** includes a capacitor **501** (see FIG. 5). The current to output terminal **454** is rectified by the first current mirror **461** meaning that the fast-decay current is positive only and feeds, i.e., charges, the capacitor **501** in the integrator **480.** The fast-decay current is propagated when the pulse **210** turns on switch **465** to drive the first current mirror **461,** assuming G_{M}(V_{IN} - V_{OUT}) is positive. That way, the voltage of the capacitor **501** quickly increases when the RESET signal enables current to flow through current mirror **461.**

During attack mode, the transconductance amplifier **450** provides a positive current Gₘ(V_{OUT} - V_{IN}) at the terminal **455** as long as an output voltage of the minimum peak detector **202** is higher than the voltage of the analog signal **121.** In one embodiment, Gₘ has a value of approximately 1mA/V. In one embodiment, V_{OUT} has a value between 0V and 1V, and V_{IN} has a value between 0V and 1V. In response to the current to output terminal **454,** the first current mirror **461** outputs a fast-decay current when the switch **465** is conductive which occurs when the RESET signal is high. In one embodiment, the fast-decay current is 0.6mA and lasts for 3ns. The minimum peak detector **202** includes a slow decay current source **470** coupled between V_{DD} and the input terminal **481** of the integrator **480.** A small slow decay current charges the capacitor (see FIGs. 5 and 6) in the integrator **480** continuously but only slowly. That way, V_{MIN}, the output voltage of the minimum peak detector **202,** advantageously tends to almost hold to a minimum input voltage. An output current of the first current mirror **461** is a fast-decay current which has a same direction as the slow decay current source **470.** The fast-decay current only occurs during reset of the minimum peak detector **202.** As shown in the example of FIG. 7, reset of the minimum peak detector **202** occurs for only the first approximately 3ns of a packet.

The minimum peak detector **202** includes a second current mirror **462** coupled between the fifth terminal **455** of the transconductance amplifier **450** and ground potential, or Vss. The transconductance amplifier **450** outputs the current (max Gₘ(V_{OUT}- V_{IN}), 0A) from the fifth terminal **455.** In response to the current from the fifth terminal **455** of the transconductance amplifier **450,** the second current mirror **462** outputs a fast attack current. This current is rectified meaning that it is positive only, as indicated by the direction of the fast-attack-current arrow in FIG. 4, and it discharges the capacitor in the integrator **480.** That way, a voltage of the capacitor in the integrator **480** quickly decreases as long as the voltage at the output terminal **238** of the minimum peak detector **202** remains higher than the voltage at the first input terminal **236** of the minimum peak detector. In one embodiment, the fast attack current is less than 0.3mA (and less than 50µA most of the time) and lasts for 3ns or less. In one embodiment, the second current mirror **462** has an amplification factor of "5".

**FIG. 5** is a simplified functional block diagram of a first example of an integrator **320** and **480** in accordance with one embodiment of the invention. FIG. 5 is an example of an integrator **320** and **480** comprising a capacitor **501** followed by an active follower circuit including an operational amplifier **502.** The voltage of the capacitor **501** is buffered by the operational amplifier **502** connected as an active voltage follower. During reset, a positive component of the output current from the fourth terminal **454** of the transconductance amplifier **450** feeds the capacitor **501** through the first current mirror **461.** In one embodiment, a size of capacitor **501** is 1ρF. A voltage across the capacitor **501** constitutes V_{MAX}, the output signal of the maximum peak detector **201,** or constitutes V_{MIN}, the output signal of the minimum peak detector **202.** During attack mode of the maximum peak detector **201,** the capacitor **501** in integrator **320** is charged quickly, but during attack mode of the minimum peak detector **202,** the capacitor is discharged quickly. Other integrator architectures could be used.

With an inverting integrator, the attack current source and the decay current source in the peak detector must be swapped to end up with negative (instead of positive) feedback to avoid an unstable circuit.

**FIG. 6** is a simplified functional block diagram of a second example of an integrator **320** and **480** in accordance with one embodiment of the invention. FIG. 6 is an example of an inverting active integrator comprising an operational amplifier **601,** and a voltage source **602** with capacitive feedback **603.** Other inverting integrator architectures could be used.

**FIGs. 7** and **8** illustrate graphs of signals present in a simulation of the fast-settling threshold estimator shown in FIG. 2 using a semi-logarithmic RF-envelope detector; however, noise is not included in the simulation, so it appears from the simulation results that V_{THL} = (V_{MAX} + V_{MIN})/2. When optimum values of first resistor **241** and second resistor **242** are used with a semi-logarithmic RF-envelope detector based on the presence of noise, first resistor **241** and second resistor **242** would not be equal and V_{THL} ≠ (V_{MAX} + V_{MIN})/2. The graphs in FIGs. 7 and 8 illustrate that the fast-settling threshold estimator **102** functions when the amplitude of the RF analog signal **101** is binary modulated between -12dBm and -32dBm as measured at the input to the RF low-noise amplifier **110,** wherein the 20dB difference is equivalent to a factor often in signal strength (voltage or current). However, the fast-settling threshold estimator **102** is not limited to functioning only within the aforementioned range of signal strength. FIG. 8 illustrates an example of a packet with a four-bit preamble of "1101". The fast-settling threshold estimator **102** is also compatible with the BLUETOOTH^{®} protocol which has a preamble that starts with "1010". However, the preamble of "1101" used in the simulation results shown in FIGs. 7 and 8 demonstrates that the fast-settling threshold estimator **102** is not limited for use with the preamble of the BLUETOOTH protocol but is also effective for use with other preambles.

Referring now specifically to FIG. 8, the voltage of the output signal V_{MAX} of the maximum peak detector **201** follows the voltage of the analog signal **121** for about the first 3ns of the packet because the maximum peak detector is initially in attack mode and the large fast attack current causes V_{MAX}, the output signal of the maximum peak detector, to increase in unison with the analog signal. Thereafter, V_{MAX} slowly decreases due to the presence of the small slow decay current. However, upon occurrence of V_{MAX} being lower than the analog signal **121,** at about 10ns after start of the packet, V_{MAX} advantageously quickly rises to the voltage of the analog signal **121** because the large fast attack current becomes activated. The data rate of the signal shown in FIG. 8 is 600Mb per second.

Referring now specifically to FIG. 7, the voltage of V_{MIN}, the output signal of the minimum peak detector **202,** advantageously follows the voltage of the analog signal **121** while pulse **210,** the output signal of comparator **204,** is high. In the example simulation of FIG. 7, pulse **210** is high for about the first 3ns of the packet. In accordance with the invention, the output signal of the comparator **204** is high because the differentiator **203** detected, for about the first 3ns of the packet, a high rate of change in V_{MAX}, the voltage of the output signal of the maximum peak detector **201.** As discussed hereinabove, the high output signal of the comparator **204** causes a large fast-settling, or fast-decay, current to occur in the minimum peak detector **202** thereby advantageously quickly producing a large voltage at the output terminal **238** of the minimum peak detector. As a result, the minimum peak detector **202** tracks the analog signal **121** better than known threshold estimators. The large fast-decay current has a same direction as the small slow-decay current because current mirror **461** and slow decay current source **470** are in parallel in the minimum peak detector **202.** Both the fast-decay current and the slow-decay current charge the capacitor **501,** resulting in an output voltage (V_{MIN}) increase over time. When pulse **210,** the output signal of the comparator **204,** is low, the large fast-settling current stops occurring. At this juncture, V_{MIN} slowly rises due to the presence of the small decay current in the minimum peak detector **202.** From approximately 4ns to approximately 5ns, a large fast-attack current causes V_{MIN} to track a decreasing analog signal **121.** Thereafter, V_{MIN} slowly rises due to the presence of the small decay current in the minimum peak detector **202.** However, upon occurrence of V_{MIN} being higher than the analog signal **121,** V_{MIN} advantageously quickly falls to the voltage of the analog signal **121** because the large fast attack current becomes activated.

In another embodiment (not shown), the small decay current is a function of (V_{IN} - V_{OUT}) instead of being fixed by the slow decay current source **318** and **470.** Making the small decay current proportional with (V_{IN} - V_{OUT}) would lead to a fixed time constant, instead of a fixed slope (V/s) as when the small decay current is based on the slow decay current source **318** and **470** which are fixed. A fixed time constant would make the peak detectors **201** and **202** less dependent on an actual signal amplitude/swing.

In one embodiment, the fast-settling threshold estimator **102** achieves an attack/decay ratio of about 1K. The attack/decay ratio of about 1K improves a bit error rate during a packet without needing a long preamble at the beginning of the packet.

In the embodiment of the fast-settling threshold estimator **102** shown in FIG. 2, only the output of the maximum peak detector **201** is differentiated. In another embodiment (not shown) of the fast-settling threshold estimator **102,** only the output of the minimum peak detector **202** is differentiated and via a comparator, a reset input terminal of the maximum peak detector **201** is controlled. In yet another embodiment (not shown) of the fast-settling threshold estimator **102,** the output of the maximum peak detector **201** and the output of the minimum peak detector **202** are differentiated.

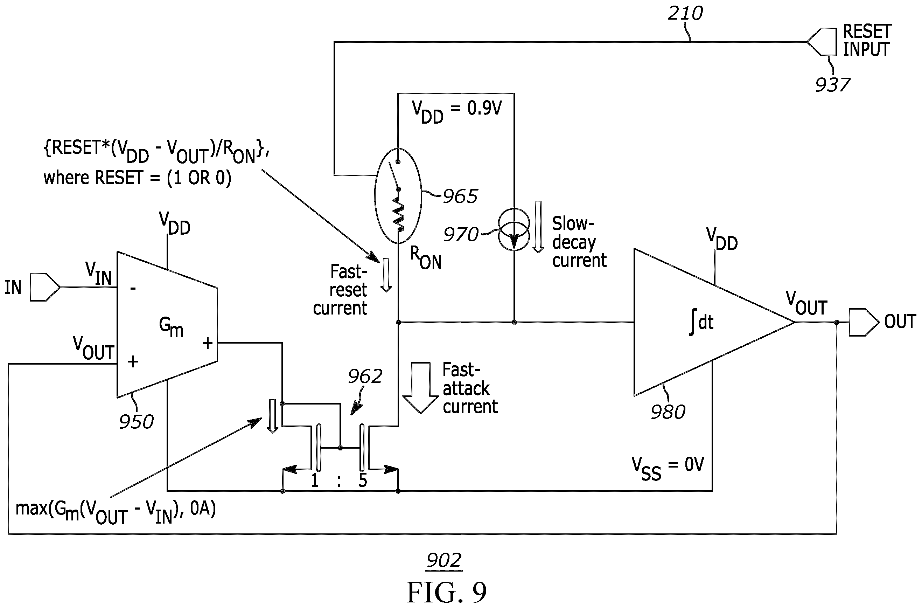

**FIG. 9** is a simplified functional block diagram of a minimum peak detector **902.** The fast-decay current in FIG. 4 has been replaced with a fast-reset current in FIG. 9. As long as RESET=0, both the fast-decay current in FIG. 4 and the fast-reset current in FIG. 9 are zero, and the operation of the minimum peak detector **202** is similar to the operation of the minimum peak detector **902.**

The minimum peak detector **902** includes a transconductance amplifier **950** having an input terminal for receiving the analog signal **121,** an input terminal coupled to an output terminal of the minimum peak detector, a terminal coupled to V_{DD}, a terminal coupled to Vss, and an output terminal. The minimum peak detector **902** includes a switch **965** with one end coupled to V_{DD}. The switch has a small on-resistance R_{ON}. In one embodiment, R_{ON} has a value in the order of 0.5KQ. The minimum peak detector **902** includes a non-inverting integrator **980** having an input terminal coupled to another end of the switch **965,** a terminal coupled to V_{DD}, a terminal coupled to Vss, and an output terminal. The minimum peak detector **902** includes a slow-decay current source **970** coupled between V_{DD} and the input terminal of the integrator **980.** The minimum peak detector **902** includes a current mirror **962** having an input transistor and an output transistor. The input transistor has a drain electrode coupled to the output terminal of the transconductance amplifier **950** and a source electrode coupled to Vss. The output transistor has a drain electrode coupled to the input terminal of the integrator **980** and a source electrode coupled to Vss. A control terminal of the switch **965** is coupled to a reset input terminal **937.** The state of the switch **965** is controlled by the pulse **210.**

Assuming that the input voltage V_{IN} is decreasing over time and that it is smaller than the output voltage V_{OUT}, the operation of the minimum peak detector **902** is as follows: If the input voltage V_{IN} is smaller than the output voltage V_{OUT}, then the transconductance amplifier **950** outputs, i.e., sources, an output current, which is proportional to a difference between V_{OUT} and V_{IN}, to the input transistor of the current mirror **962.** The output current is expressed as {max(Gₘ(V_{OUT} - V_{IN}), 0A)}. The current mirror **962** amplifies, i.e., multiplies, the output current with a factor of "5", resulting in a large attack current at the output transistor of the current mirror **962** which discharges the capacitor **501** of the integrator **980.** Because the attack current is large, the aforementioned discharge is fast, and therefore the large attack current is called a fast-attack current. The continuously-flowing slow-decay current counteracts this discharge, but because the slow-decay current is very small, this effect is negligible. The output voltage V_{OUT} equals the voltage across the capacitor **501.** Because the capacitor **501** is discharged rapidly, the output voltage V_{OUT} rapidly decreases and tends to follow the input voltage V_{IN}. However, the tracking is not exact because a small voltage difference between V_{OUT} and V_{IN} remains. This small voltage difference is needed for the transconductance amplifier **950** to generate its output current, which is proportional to this small voltage difference, and therefore the discharging of the capacitor **501** continues. The aforementioned process stops when the input voltage V_{IN} has reached a local minimum. In this way, the output voltage V_{OUT} keeps track of the minimum value of the input voltage V_{IN}. The output voltage V_{OUT} can be regarded as an estimate of the minimum value of the input voltage V_{IN}. It approximately equals the minimum value of the input voltage V_{IN} found so far.

Assuming that at this juncture, the input voltage V_{IN} starts to increase; and, therefore, it will be larger than the output voltage V_{OUT}. Consequently, the transconductance amplifier **950** attempts to reverse the direction of its output current. Instead of sourcing an output current, transconductance amplifier **950** attempts to sink an output current. However, the input transistor of the current mirror **962,** which is configured as a rectifying diode (gate connected to drain), blocks this attempt and as a result, the output current of the transconductance amplifier **950** becomes zero. Therefore, the attack current, which is the amplified version of the output current of the transconductance amplifier **950,** also becomes zero. Now the only current left, is the small decay current. The small decay current slowly charges the capacitor **501.** As a result, the output voltage V_{OUT} slowly increases. Because a rate of change of the voltage across the capacitor **501** versus time is only slightly positive, the output voltage V_{OUT} tends to hold onto the minimum value found so far. This behavior can be considered a (leaky) memory function.

In a next cycle of the analog signal **121,** the input voltage V_{IN} could again become lower than the output voltage V_{OUT'} which approximately equals the minimum value of the input voltage V_{IN} found so far, and the aforesaid process repeats.

Without additional measures, the minimum peak detector **902** would have a long settling time at the beginning of a packet caused by its slow decay due to the small decay current. The long settling time is significantly reduced by utilizing a RESET signal that is controlled by the (binary quantized) time derivative of the output signal **205** of the maximum peak detector **201.** The minimum peak detector **902** receives the RESET signal at the reset input terminal **937.**

Resetting the minimum peak detector **902** means initializing the output voltage of the minimum peak detector to a high voltage level. If the RESET signal becomes high, then the switch **965** becomes conductive and the input voltage of the integrator **980** is pulled up towards V_{DD}. The output voltage V_{OUT} closely follows the input voltage of the integrator **980** because of a voltage buffer/follower in the integrator. The slow-decay current contributes constructively, but its contribution is negligible because it is a very small current. Because the reset current is only limited by the small on-resistance R_{ON} of the switch **965,** it is a large current; and therefore, capacitor **501** is charged quickly. Very soon thereafter, the output voltage V_{OUT} becomes larger than the input voltage V_{IN} and, as a result, the minimum peak detector **902** starts attacking. Therefore, a value of the output voltage V_{OUT} becomes between V_{DD} and V_{IN}. The value of the output voltage V_{OUT} in the minimum peak detector **902** is slightly higher than that in the minimum peak detector **202** where it is slightly below V_{IN} (fast-decay mode during reset). The fast-reset current is expressed as {RESET * (V_{DD}-V_{OUT}) / R_{ON}}, where RESET = (1 or 0).

Any additional current consumption due to the reset current and the attack current flowing at the same time, is negligible because the RESET signal is only one narrow pulse, pulse **210,** at a beginning of the packet. In one embodiment (not shown) a switch is inserted in the output lead of the transconductance amplifier **950.** Such switch is controlled by the RESET signal and is non-conductive during reset, to prevent an attack current during reset. The minimum peak detector **902** consumes less current than the minimum peak detector **202** because the minimum peak detector **902** uses a single-output transconductance amplifier instead of a dual-output transconductance amplifier, thereby reducing bias-current consumption.

The minimum peak detector **902** also works with an inverting integrator, after swapping the current sources and the switch. With the minimum peak detector **902,** the reset current is independent of V_{IN}.

If the input voltage V_{IN} is smaller than the output voltage V_{OUT'} then the transconductance amplifier **950** sources an output current proportional to the difference between V_{OUT} and V_{IN}. The output current is equal to this voltage difference times a transconductance Gₘ of approximately 1mA/V. If the input voltage V_{IN} equals the output voltage V_{OUT'} then the transconductance amplifier **950** does not output any output current. If the input voltage V_{IN} is larger than the output voltage V_{OUT}, then the transconductance amplifier **950** attempts to sink an output current. However, the input transistor of the current mirror **962,** which is configured as a rectifying diode (gate connected to drain), blocks this attempt and as a result, the output current of the transconductance amplifier **950** is zero.

The current mirror **962** rectifies and amplifies the output current of the transconductance amplifier **950.** The output current of the transconductance amplifier **950** is amplified, i.e., multiplied with a factor of "5" by the current mirror **962** and the product of this multiplication is the output current of the current mirror, which is the fast-attack current.

The slow-decay current source **970** generates a small decay current of approximately 1µA in one embodiment.

If the RESET signal is low, then the switch **965** is non-conductive and there is no current through the switch **965.** If the RESET signal is high (at the beginning of a data packet), then the current through the switch **965** is the fast-reset current and is proportional to a difference between the supply voltage V_{DD} and the input voltage of the integrator **980** (which equals V_{OUT} due to an internal voltage buffer/follower of the integrator). The fast-reset current is equal to this voltage difference divided by the on-resistance R_{ON} of the switch **965** which, in one embodiment, is approximately 0.5KΩ.

According to Kirchhoff's current law, the input current of the integrator **980** is equal to the slow-decay current plus the fast-reset current minus the fast-attack current. The input current of the integrator **980** is integrated by capacitor **501.** In one embodiment, capacitor **501** has a value of approximately 1ρF. The voltage across the capacitor **501** is buffered by the internal voltage buffer/follower to prevent disturbing charge currents or discharge currents due to an external load (not shown) of the minimum peak detector **202.** The output voltage V_{OUT} is equal to the voltage across capacitor **501.** The rate of change (V/s) of the output voltage V_{OUT} is equal to the input current of the integrator **980** divided by the capacitance of capacitor **501.**

During attack, the output voltage V_{OUT} tracks the input voltage V_{IN'} in good approximation. By reasoning backward, it follows that the difference between V_{OUT} and V_{IN'} which can be considered as a (dynamic) tracking error, is approximately equal to the rate of change (V/s) of the input voltage V_{IN} multiplied by the capacitance of capacitor **501** and divided by five times the transconductance Gₘ.

A fast-settling threshold estimator **102** for determining a fast-settling threshold voltage V_{THL} comprises a maximum peak detector **201** for receiving an analog signal **121,** the analog signal containing digital data, wherein the maximum peak detector produces at its output terminal an estimate of a maximum value of the analog signal within a predetermined time range; a differentiator **203** coupled to the maximum peak detector, wherein the differentiator produces an output voltage having a value responsive to a change in the estimate of the maximum value of the analog signal; a constant voltage source **215** having a preselected voltage; a comparator **204** having a first input terminal **231** coupled to the differentiator and a second input terminal **232** coupled to the constant voltage source, wherein the comparator outputs a pulse **210** when the output voltage of the differentiator is greater than the preselected voltage; a minimum peak detector **202** having a first input terminal **236** for receiving the analog signal and a reset input terminal **237** for receiving the pulse, wherein the pulse resets the minimum peak detector and, after being reset, the minimum peak detector produces at its output terminal an estimate of a minimum value of the analog signal within a predetermined time range; and an averaging circuit **235** coupled to the maximum peak detector and to the minimum peak detector for producing a weighted average of the estimate of the maximum value of the analog signal and the estimate of the minimum value of the analog signal, wherein the weighted average is the fast-settling threshold voltage.

An electronic circuit **100** for determining a slicing level of digital data in an analog signal comprises a bit-slicing voltage comparator **104** having a positive input terminal **131** for receiving an analog signal **121** containing digital data, a negative input terminal **132,** and an output terminal for outputting a binary signal based on the digital data; and a fast-settling threshold estimator **102** for producing a fast-settling threshold voltage V_{THL}, the fast-settling threshold estimator having an input terminal **126** for receiving the analog signal and an output terminal **128** coupled to the negative input terminal of the bit-slicing voltage comparator. The fast-settling threshold estimator includes a maximum peak detector **201** having an input terminal **220** for receiving the analog signal and having an output terminal **221,** wherein the maximum peak detector produces at its output terminal an estimate of a maximum value of the analog signal; a differentiator **203** having an input terminal **223** coupled to the output terminal of the maximum peak detector, and having an output terminal, wherein the differentiator produces an output signal **205** responsive to a change in the analog signal; a second comparator **204** having a first input terminal **231** coupled to the differentiator and a second input terminal **232** coupled to a constant voltage source **215** having a preselected voltage and having an output terminal, wherein the second comparator outputs a pulse **210** when a voltage of the output signal of the differentiator is greater than the preselected voltage; and a minimum peak detector **202** having a first input terminal **236** for receiving the analog signal and a reset input terminal **237** for receiving the pulse, wherein the pulse resets the minimum peak detector and, after being reset, the minimum peak detector outputs at an output terminal an estimate of a minimum value of the analog signal. The fast-settling threshold estimator also includes an averaging circuit **235** coupled to the maximum peak detector and to the minimum peak detector for producing a weighted average of the estimate of a maximum value of the analog signal and the estimate of a minimum value of the analog signal, wherein the weighted average is the fast-settling threshold voltage V_{THL} of a slicing level of the digital data.

A radio frequency (RF) receiver **103** comprises an RF low-noise amplifier **110** coupled to an antenna **112** for receiving digital data in an RF analog signal **101;** an RF-envelope detector **114** coupled to the RF low-noise amplifier for downmixing the RF analog signal and for outputting a baseband analog signal; a semi-logarithmic baseband transimpedance amplifier **116** coupled to the RF-envelope detector; a baseband low-pass filter **120** having an input coupled to the semi-logarithmic baseband transimpedance amplifier and having an output terminal; a fast-settling threshold estimator **102** having an input terminal **126** coupled to the output terminal of the baseband low-pass filter and having an output terminal **128** for outputting a fast-settling threshold voltage V_{THL}; and a bit slicer **104** having a first input terminal **131** coupled to the output terminal of the baseband low-pass filter and a second input terminal **132** coupled to the output terminal of the fast-settling threshold estimator, wherein the bit slicer outputs a binary signal responsive to the digital data in the analog RF signal and responsive to the fast-settling threshold voltage.

One or more embodiments of the present disclosure may include features recited in the following numbered clauses:
1. A fast-settling threshold estimator for determining a fast-settling threshold voltage, comprising: a maximum peak detector for receiving an analog signal, the analog signal containing digital data, wherein the maximum peak detector produces at its output terminal an estimate of a maximum value of the analog signal within a predetermined time range; a differentiator coupled to the maximum peak detector, wherein the differentiator produces an output voltage having a value responsive to a change in the estimate of the maximum value of the analog signal; a constant voltage source having a preselected voltage; a comparator having a first input terminal coupled to the differentiator and a second input terminal coupled to the constant voltage source, wherein the comparator outputs a pulse when the output voltage of the differentiator is greater than the preselected voltage; a minimum peak detector having a first input terminal for receiving the analog signal and a reset input terminal for receiving the pulse, wherein the pulse resets the minimum peak detector and, after being reset, the minimum peak detector produces at its output terminal an estimate of a minimum value of the analog signal within a predetermined time range; and an averaging circuit coupled to the maximum peak detector and to the minimum peak detector for producing a weighted average of the estimate of the maximum value of the analog signal and the estimate of the minimum value of the analog signal, wherein the weighted average is a fast-settling threshold voltage.
2. The fast-settling threshold estimator of claim 1, wherein the differentiator outputs a voltage that is linear with a rate of change in the analog signal.
3. The fast-settling threshold estimator of claim 2, including a bit slicer wherein, based in part on the fast-settling threshold voltage, the bit slicer outputs a binary signal corresponding to the digital data.
4. The fast-settling threshold estimator of claim 3, wherein the bit slicer comprises a bit-slicing voltage comparator having an input terminal for receiving the analog signal and an input terminal for receiving the fast-settling threshold voltage, wherein an output of the bit-slicing voltage comparator comprises the binary signal.
5. The fast-settling threshold estimator of claim 1, wherein the maximum peak detector includes a transconductance amplifier having a first input terminal for receiving the analog signal, and a second input terminal coupled to the output terminal of the maximum peak detector, a terminal coupled to VDD, and a terminal coupled to VSS, wherein the transconductance amplifier produces an output current; a current mirror having an input transistor coupled to the output terminal of the transconductance amplifier, and an output transistor, wherein the current mirror rectifies and amplifies the output current of the transconductance amplifier; a slow decay current source coupled between the output transistor and VSS; and an integrator having an input terminal coupled to the output transistor, a terminal coupled to VDD, a terminal coupled to VSS, and an output terminal, wherein the integrator outputs the estimate of the maximum voltage of the analog signal.
6. The fast-settling threshold estimator of claim 5, wherein the transconductance amplifier is configured to produce the output current proportional to a difference between a voltage of the analog signal and a voltage of the output terminal of the maximum peak detector.
7. The fast-settling threshold estimator of claim 1, wherein the minimum peak detector includes a transconductance amplifier having a first terminal for receiving the analog signal, a second terminal coupled to an output terminal of the minimum peak detector, a third terminal coupled to VDD, a fourth terminal, a fifth terminal, and a sixth terminal coupled to VSS, wherein the transconductance amplifier produces a first output current and a second output current; a first current mirror, coupled to VDD, having an input transistor and an output transistor; a switch coupled between the fourth terminal of the transconductance amplifier and the input transistor of the first current mirror, the switch controlled by the pulse, wherein the first current mirror rectifies and amplifies the first output current depending on a state of the switch; a second current mirror having an input transistor coupled between the fifth terminal and VSS, and having an output transistor, wherein the second current mirror rectifies and amplifies the second output current of the transconductance amplifier; an integrator having an input terminal coupled to the output transistor of the first current mirror and to the output terminal of the second current mirror, a terminal coupled to VDD, a terminal coupled to VSS, and an output terminal; and a slow-decay current source coupled between VDD and the input terminal of the integrator, wherein the integrator outputs the estimate of the minimum voltage of the analog signal.
8. The fast-settling threshold estimator of claim 7, wherein the transconductance amplifier is configured to output the first output current proportional to a difference between a voltage of the output terminal of the minimum peak detector and a voltage of the analog signal, and to output the second output current proportional to a difference between a voltage of the output terminal of the minimum peak detector and a voltage of the analog signal.
9. The fast-settling threshold estimator of claim 1, wherein the output voltage of the differentiator is KdVMAX/dt, where K is a gain factor, VMAX is the estimate of the maximum value of the analog signal, and t is time.
10. An electronic circuit for determining a slicing level of digital data in an analog signal, comprising: a bit-slicing voltage comparator having a positive input terminal for receiving an analog signal containing digital data, a negative input terminal, and an output terminal for outputting a binary signal based on the digital data; a fast-settling threshold estimator for producing a fast-settling threshold voltage, the fast-settling threshold estimator having an input terminal for receiving the analog signal and an output terminal coupled to the negative input terminal of the bit-slicing voltage comparator, wherein the fast-settling threshold estimator includes: a maximum peak detector having an input terminal for receiving the analog signal and having an output terminal, wherein the maximum peak detector produces at its output terminal an estimate of a maximum value of the analog signal, a differentiator having an input terminal coupled to the output terminal of the maximum peak detector, and having an output terminal, wherein the differentiator produces an output signal responsive to a change in the analog signal, a second comparator having a first input terminal coupled to the differentiator and a second input terminal coupled to a constant voltage source having a preselected voltage and having an output terminal, wherein the second comparator outputs a pulse when a voltage of the output signal of the differentiator is greater than the preselected voltage, and a minimum peak detector having a first input terminal for receiving the analog signal and a reset input terminal for receiving the pulse, wherein the pulse resets the minimum peak detector and, after being reset, the minimum peak detector outputs at an output terminal an estimate of a minimum value of the analog signal; and an averaging circuit coupled to the maximum peak detector and to the minimum peak detector for producing a weighted average of the estimate of a maximum value of the analog signal and the estimate of a minimum value of the analog signal, wherein the weighted average is a fast-settling threshold voltage of a slicing level of the digital data.
11. The electronic circuit of claim 10, wherein the maximum peak detector includes a transconductance amplifier having a terminal for receiving the analog signal, a terminal coupled to the output terminal of the maximum peak detector, a terminal coupled to VDD and a terminal coupled to VSS, wherein the transconductance amplifier is configured to output a current proportional to a difference between a voltage of the analog signal and a voltage of the output terminal of the maximum peak detector; a current mirror having an input transistor coupled to the output terminal of the transconductance amplifier, and an output transistor, wherein the current mirror rectifies and amplifies the current of the transconductance amplifier; a slow decay current source coupled between the output transistor and VSS; and an integrator having an input terminal coupled to the output transistor, a terminal coupled to VSS, and an output terminal, wherein integrator outputs the estimate of a maximum voltage of the analog signal.
12. The electronic circuit of claim 11, wherein the integrator includes a capacitor coupled between the input terminal and VSS; and an operational amplifier having a positive input coupled to the input terminal of the integrator, an output coupled to the output terminal of the integrator, and a negative input, wherein the output of the operational amplifier is coupled to the negative input of the operational amplifier in an active follower configuration.
13. The electronic circuit of claim 11 wherein, when the voltage of the output terminal of the maximum peak detector is less than the voltage of the analog signal, the current mirror outputs a fast-attack current proportional to the output current of the transconductance amplifier.
14. The electronic circuit of claim 10, wherein the minimum peak detector includes a transconductance amplifier having a negative input terminal for receiving the analog signal, a positive input terminal coupled to an output terminal of the minimum peak detector, a terminal coupled to VDD, a terminal coupled to VSS, and an output terminal, wherein the transconductance amplifier is configured to output an output current proportional to a difference between a voltage at the output terminal and the voltage of the analog signal; a current mirror for rectifying and amplifying the output current of the transconductance amplifier, the current mirror having an input transistor and an output transistor, wherein a drain electrode of the input transistor is coupled to the output terminal of the transconductance amplifier and a source electrode of the input transistor is coupled to VSS; a switch coupled between the VDD and a drain electrode of the output transistor, the switch controlled by the pulse, wherein the source electrode of the output transistor is coupled to VSS; an integrator having an input terminal coupled to the drain electrode of the output transistor, a terminal coupled to VDD, a terminal coupled to VSS, and an output terminal coupled to the output terminal of the minimum peak detector; and a slow-decay current source coupled between the VDD and the input terminal of the integrator, wherein, when the switch is conducting, a fast-reset current is sourced to the input terminal of the integrator, and wherein the integrator outputs the estimate of a minimum voltage of the analog signal.
15. The electronic circuit of claim 14, wherein the minimum peak detector produces the fast-reset current to the input terminal of the integrator based on an expression {RESET * (VDD - VOUT) / RON}, where RON is an on-resistance of the switch, where RESET = (1 or 0), and where RESET is set by the pulse.
16. A radio frequency (RF) receiver, comprising: an RF low-noise amplifier coupled to an antenna for receiving digital data in an RF analog signal; an RF-envelope detector coupled to the RF low-noise amplifier for downmixing the RF analog signal and for outputting a baseband analog signal; a semi-logarithmic baseband transimpedance amplifier coupled to the RF-envelope detector; a baseband low-pass filter having an input coupled to the semi-logarithmic baseband transimpedance amplifier and having an output terminal; a fast-settling threshold estimator having an input terminal coupled to the output terminal of the baseband low-pass filter and having an output terminal for outputting a fast-settling threshold voltage; and a bit slicer having a first input terminal coupled to the output terminal of the baseband low-pass filter and a second input terminal coupled to the output terminal of the fast-settling threshold estimator, wherein the bit slicer outputs a binary signal responsive to the digital data in the analog RF signal and responsive to the fast-settling threshold voltage.
17. The radio frequency receiver of claim 16, wherein the bit slicer includes a bit-slicing voltage comparator having a first input for receiving the baseband analog signal and a second input coupled to the output terminal of the fast-settling threshold estimator, wherein an output of the bit-slicing voltage comparator comprises the binary signal.
18. The radio frequency receiver of claim 16, wherein the fast-settling threshold estimator includes a maximum peak detector for receiving an analog signal, wherein the maximum peak detector produces an estimate of a maximum value of the analog signal at its output terminal; a differentiator having an input terminal coupled to the maximum peak detector, wherein the differentiator produces at its output terminal an output voltage responsive to a change in the maximum value of the analog signal; a comparator having a first input terminal coupled to the differentiator and a second input terminal coupled to a constant voltage source and having an output terminal, wherein the comparator outputs a pulse when the output voltage of the differentiator is greater than a voltage of the constant voltage source; a minimum peak detector having a first input terminal for receiving the analog signal and a reset input terminal for receiving the pulse, wherein the pulse resets the minimum peak detector and, after being reset, the minimum peak detector produces an estimate of a minimum value of the analog signal at its output terminal; a first resistor having one end coupled to the output terminal of the maximum peak detector and another end coupled to a node; and a second resistor having one end coupled to the output terminal of the minimum peak detector and another end coupled to the node, wherein a voltage at the node is a fast-settling threshold voltage.
19. The radio frequency receiver of claim 18, wherein the maximum peak detector includes a transconductance amplifier having a first input terminal for receiving the analog signal, and a second input terminal coupled to the output terminal of the maximum peak detector, a terminal coupled to VDD and a terminal coupled to VSS, wherein the transconductance amplifier is configured to produce an output current proportional to a difference between a voltage of the analog signal and a voltage of the output terminal of the maximum peak detector; a current mirror, coupled to VDD, having an input transistor coupled to the output terminal of the transconductance amplifier, and an output transistor, wherein the current mirror rectifies and amplifies the output current of the transconductance amplifier; a slow decay current source coupled between the output transistor and VSS; and an integrator having an input terminal coupled to the output transistor, a terminal coupled to VDD, a terminal coupled to VSS, and an output terminal, wherein integrator outputs the estimate of a maximum voltage of the analog signal.
20. The radio frequency receiver of claim 18, wherein the minimum peak detector includes a transconductance amplifier having a negative input terminal for receiving the analog signal, a positive input terminal coupled to an output terminal of the minimum peak detector, a third terminal coupled to VDD, a fourth terminal, a fifth terminal coupled to a second current mirror, and a sixth terminal coupled to VSS, wherein the transconductance amplifier is configured to output two currents proportional to a difference between a voltage of the output terminal of the minimum peak detector and a voltage of the analog signal; a first current mirror having an input transistor and an output transistor; a switch coupled between the fourth terminal of the transconductance amplifier and the input transistor of the first current mirror, the switch controlled by the pulse, wherein the first current mirror rectifies and amplifies a first output current depending on a state of the switch; a second current mirror having an input transistor coupled between the fifth terminal and VSS, and having an output transistor, wherein the second current mirror rectifies and amplifies a second output current of the transconductance amplifier; an integrator having an input terminal coupled to the output transistor of the first current mirror and to the output terminal of the second current mirror, a terminal coupled to VDD, a terminal coupled to VSS, and an output terminal; and a slow-decay current source coupled between VDD and the input terminal of the integrator, wherein the integrator outputs the estimate of a minimum voltage of the analog signal.

The term "coupled", as used herein, is defined as "connected", and encompasses the coupling of devices that may be physically, electrically or communicatively connected, although the coupling may not necessarily be directly, and not necessarily be mechanically. The term "configured to" describes hardware, software or a combination of hardware and software that is adapted to, set up, arranged, built, composed, constructed, designed or that has any combination of these characteristics to carry out a given function.

The terms "a" or "an", as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an". The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements.

The Detailed Description section, and not the Abstract section, is intended to be used to interpret the claims. The Abstract section may set forth one or more but not all embodiments of the invention, and the Abstract section is not intended to limit the invention or the claims in any way.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages or solutions to problems that are described herein with regard to specific embodiments are not intended to be construed as a critical, required, or essential feature or element of any or all the claims.

## Claims

1. A fast-settling threshold estimator for determining a fast-settling threshold voltage, comprising:
a maximum peak detector for receiving an analog signal, the analog signal containing digital data, wherein the maximum peak detector produces at its output terminal an estimate of a maximum value of the analog signal within a predetermined time range;
a differentiator coupled to the maximum peak detector, wherein the differentiator produces an output voltage having a value responsive to a change in the estimate of the maximum value of the analog signal;
a constant voltage source having a preselected voltage;
a comparator having a first input terminal coupled to the differentiator and a second input terminal coupled to the constant voltage source, wherein the comparator outputs a pulse when the output voltage of the differentiator is greater than the preselected voltage;
a minimum peak detector having a first input terminal for receiving the analog signal and a reset input terminal for receiving the pulse, wherein the pulse resets the minimum peak detector and, after being reset, the minimum peak detector produces at its output terminal an estimate of a minimum value of the analog signal within a predetermined time range; and
an averaging circuit coupled to the maximum peak detector and to the minimum peak detector for producing a weighted average of the estimate of the maximum value of the analog signal and the estimate of the minimum value of the analog signal, wherein the weighted average is a fast-settling threshold voltage.

2. The fast-settling threshold estimator of claim 1, wherein the differentiator outputs a voltage that is linear with a rate of change in the analog signal.

3. The fast-settling threshold estimator of claim 1 or 2, including a bit slicer wherein, based in part on the fast-settling threshold voltage, the bit slicer outputs a binary signal corresponding to the digital data.

4. The fast-settling threshold estimator of claim 3, wherein the bit slicer comprises a bit-slicing voltage comparator having an input terminal for receiving the analog signal and an input terminal for receiving the fast-settling threshold voltage, wherein an output of the bit-slicing voltage comparator comprises the binary signal.

5. The fast-settling threshold estimator of any of claims 1 to 4, wherein the maximum peak detector includes:
a transconductance amplifier having a first input terminal for receiving the analog signal, and a second input terminal coupled to the output terminal of the maximum peak detector, a terminal coupled to V_{DD}, and a terminal coupled to Vss, wherein the transconductance amplifier produces an output current;
a current mirror having an input transistor coupled to the output terminal of the transconductance amplifier, and an output transistor, wherein the current mirror rectifies and amplifies the output current of the transconductance amplifier;
a slow decay current source coupled between the output transistor and Vss; and
an integrator having an input terminal coupled to the output transistor, a terminal coupled to V_{DD}, a terminal coupled to Vss, and an output terminal, wherein the integrator outputs the estimate of the maximum voltage of the analog signal.

6. The fast-settling threshold estimator of claim 5, wherein the transconductance amplifier is configured to produce the output current proportional to a difference between a voltage of the analog signal and a voltage of the output terminal of the maximum peak detector.

7. The fast-settling threshold estimator of any of claims 1 to 4, wherein the minimum peak detector includes
a transconductance amplifier having a first terminal for receiving the analog signal, a second terminal coupled to an output terminal of the minimum peak detector, a third terminal coupled to V_{DD}, a fourth terminal, a fifth terminal, and a sixth terminal coupled to Vss, wherein the transconductance amplifier produces a first output current and a second output current;
a first current mirror, coupled to V_{DD}, having an input transistor and an output transistor;
a switch coupled between the fourth terminal of the transconductance amplifier and the input transistor of the first current mirror, the switch controlled by the pulse, wherein the first current mirror rectifies and amplifies the first output current depending on a state of the switch;
a second current mirror having an input transistor coupled between the fifth terminal and Vss, and having an output transistor, wherein the second current mirror rectifies and amplifies the second output current of the transconductance amplifier;
an integrator having an input terminal coupled to the output transistor of the first current mirror and to the output terminal of the second current mirror, a terminal coupled to V_{DD}, a terminal coupled to Vss, and an output terminal; and
a slow-decay current source coupled between V_{DD} and the input terminal of the integrator,
wherein the integrator outputs the estimate of the minimum voltage of the analog signal.

8. The fast-settling threshold estimator of claim 7, wherein the transconductance amplifier is configured to output the first output current proportional to a difference between a voltage of the output terminal of the minimum peak detector and a voltage of the analog signal, and to output the second output current proportional to a difference between a voltage of the output terminal of the minimum peak detector and a voltage of the analog signal.

9. The fast-settling threshold estimator of any of the preceding claims, wherein the output voltage of the differentiator is KdV_{MAX}/dt, where K is a gain factor, V_{MAX} is the estimate of the maximum value of the analog signal, and t is time.

10. An electronic circuit for determining a slicing level of digital data in an analog signal, comprising:
a bit-slicing voltage comparator having a positive input terminal for receiving an analog signal containing digital data, a negative input terminal, and an output terminal for outputting a binary signal based on the digital data;
a fast-settling threshold estimator for producing a fast-settling threshold voltage, the fast-settling threshold estimator having an input terminal for receiving the analog signal and an output terminal coupled to the negative input terminal of the bit-slicing voltage comparator, wherein the fast-settling threshold estimator includes:
a maximum peak detector having an input terminal for receiving the analog signal and having an output terminal, wherein the maximum peak detector produces at its output terminal an estimate of a maximum value of the analog signal,
a differentiator having an input terminal coupled to the output terminal of the maximum peak detector, and having an output terminal, wherein the differentiator produces an output signal responsive to a change in the analog signal,
a second comparator having a first input terminal coupled to the differentiator and a second input terminal coupled to a constant voltage source having a preselected voltage and having an output terminal, wherein the second comparator outputs a pulse when a voltage of the output signal of the differentiator is greater than the preselected voltage, and
a minimum peak detector having a first input terminal for receiving the analog signal and a reset input terminal for receiving the pulse, wherein the pulse resets the minimum peak detector and, after being reset, the minimum peak detector outputs at an output terminal an estimate of a minimum value of the analog signal; and
an averaging circuit coupled to the maximum peak detector and to the minimum peak detector for producing a weighted average of the estimate of a maximum value of the analog signal and the estimate of a minimum value of the analog signal, wherein the weighted average is a fast-settling threshold voltage of a slicing level of the digital data.

11. The electronic circuit of claim 10, wherein the maximum peak detector includes
a transconductance amplifier having a terminal for receiving the analog signal, a terminal coupled to the output terminal of the maximum peak detector, a terminal coupled to V_{DD} and a terminal coupled to Vss, wherein the transconductance amplifier is configured to output a current proportional to a difference between a voltage of the analog signal and a voltage of the output terminal of the maximum peak detector;
a current mirror having an input transistor coupled to the output terminal of the transconductance amplifier, and an output transistor, wherein the current mirror rectifies and amplifies the current of the transconductance amplifier;
a slow decay current source coupled between the output transistor and Vss; and
an integrator having an input terminal coupled to the output transistor, a terminal coupled to Vss, and an output terminal, wherein integrator outputs the estimate of a maximum voltage of the analog signal.

12. The electronic circuit of claim 11, wherein the integrator includes a capacitor coupled between the input terminal and Vss; and
an operational amplifier having a positive input coupled to the input terminal of the integrator, an output coupled to the output terminal of the integrator, and a negative input, wherein the output of the operational amplifier is coupled to the negative input of the operational amplifier in an active follower configuration.

13. The electronic circuit of claim 11 or 12, wherein, when the voltage of the output terminal of the maximum peak detector is less than the voltage of the analog signal, the current mirror outputs a fast-attack current proportional to the output current of the transconductance amplifier.

14. The electronic circuit of claim 10, wherein the minimum peak detector includes
a transconductance amplifier having a negative input terminal for receiving the analog signal, a positive input terminal coupled to an output terminal of the minimum peak detector, a terminal coupled to V_{DD}, a terminal coupled to Vss, and an output terminal, wherein the transconductance amplifier is configured to output an output current proportional to a difference between a voltage at the output terminal and the voltage of the analog signal;
a current mirror for rectifying and amplifying the output current of the transconductance amplifier, the current mirror having an input transistor and an output transistor, wherein a drain electrode of the input transistor is coupled to the output terminal of the transconductance amplifier and a source electrode of the input transistor is coupled to Vss;
a switch coupled between the V_{DD} and a drain electrode of the output transistor, the switch controlled by the pulse, wherein the source electrode of the output transistor is coupled to Vss;
an integrator having an input terminal coupled to the drain electrode of the output transistor, a terminal coupled to V_{DD}, a terminal coupled to Vss, and an output terminal coupled to the output terminal of the minimum peak detector; and
a slow-decay current source coupled between the V_{DD} and the input terminal of the integrator,
wherein, when the switch is conducting, a fast-reset current is sourced to the input terminal of the integrator, and
wherein the integrator outputs the estimate of a minimum voltage of the analog signal.

15. A radio frequency (RF) receiver, comprising:
an RF low-noise amplifier coupled to an antenna for receiving digital data in an RF analog signal;
an RF-envelope detector coupled to the RF low-noise amplifier for downmixing the RF analog signal and for outputting a baseband analog signal;
a semi-logarithmic baseband transimpedance amplifier coupled to the RF-envelope detector;
a baseband low-pass filter having an input coupled to the semi-logarithmic baseband transimpedance amplifier and having an output terminal;
a fast-settling threshold estimator having an input terminal coupled to the output terminal of the baseband low-pass filter and having an output terminal for outputting a fast-settling threshold voltage; and
a bit slicer having a first input terminal coupled to the output terminal of the baseband low-pass filter and a second input terminal coupled to the output terminal of the fast-settling threshold estimator, wherein the bit slicer outputs a binary signal responsive to the digital data in the analog RF signal and responsive to the fast-settling threshold voltage.
